Europäisches Patentamt

European Patent Office

Office européen des brevets

(19)

(11) EP 0 741 871 B1

(12) **EUROPÄISCHE PATENTSCHRIFT**

(45) Veröffentlichungstag und Bekanntmachung des Hinweises auf die Patenterteilung:
06.05.1999 Patentblatt 1999/18

(21) Anmeldenummer: 95906272.0

(22) Anmeldetag: 18.01.1995

(51) Int Cl.⁶: **G01R 19/165**

(86) Internationale Anmeldenummer:
PCT/DE95/00098

(87) Internationale Veröffentlichungsnummer:
WO 95/20765 (03.08.1995 Gazette 1995/33)

(54) **VERFAHREN ZUM ERFASSEN DES STROMES IN EINEM LEITER EINES WECHSELSTROM-ENERGIEÜBERTRAGUNGSNETZES**

METHOD OF MEASURING CURRENT IN A CONDUCTOR IN AN AC TRANSMISSION NETWORK

PROCEDE DE MESURE DU COURANT PASSANT DANS LE CONDUCTEUR D'UN RESEAU DE TRANSPORT DE COURANT ALTERNATIF

(84) Benannte Vertragsstaaten:
**CH DE FR GB LI SE**

(30) Priorität: **26.01.1994 DE 4402762**

(43) Veröffentlichungstag der Anmeldung:
**13.11.1996 Patentblatt 1996/46**

(73) Patentinhaber: **SIEMENS AKTIENGESELLSCHAFT**
**80333 München (DE)**

(72) Erfinder: **JURISCH, Andreas, Dr.**
**13587 Berlin (DE)**

(56) Entgegenhaltungen:
**EP-A- 0 355 293**

**Beschreibung**

Es ist seit langem bekannt (vgl. z.B. "etz.", Bd. 114 (1993), Heft 18, Seiten 1122 bis 1127), den Strom in einem Leiter eines Wechselstrom-Energieübertragungsnetzes mittels eines Stromwandlers zu erfassen, dessen Primärwicklung von dem Strom in dem Leiter durchflossen ist und an dessen Sekundärwicklung eine Einrichtung zum Erfassen des Stromes angeschlossen ist. Bei dieser Einrichtung kann es sich um eine Meßeinrichtung handeln oder um eine Schutzeinrichtung, wie sie in Wechselstrom-Energieübertragungsnetzen zum Erfassen und Lokalisieren von Kurzschlüssen üblich ist. Ebenso ist es seit geraumer Zeit bekannt (siehe z.B. oben genannte Literaturstelle), daß eine Verarbeitung der von der Sekundärwicklung des Stromwandlers bereitgestellten, dem Strom proportionalen Meßgröße auf digitale Weise erfolgen kann, wozu Voraussetzung ist, daß aus der Meßgröße mittels einer Abtasteinrichtung (mit Analog-Digital-Wandler) digitale Abtastwerte gebildet werden. Diese digitalen Abtastwerte werden dann in einer digitalen Meßeinrichtung oder einer digitalen Schutzeinrichtung weiter verarbeitet.

Die Erfindung geht von einem Verfahren zum Erfassen des Wechselstromes in einem Leiter eines Wechselstrom-Energieübertragungsnetzes aus, bei dem mittels eines Stromwandlers eine dem Wechselstrom proportionale Meßgröße gewonnen wird und aus der Meßgröße mittels einer Abtasteinrichtung digitale Abtastwerte gebildet werden, und stellt sich die Aufgabe, dieses Verfahren so auszugestalten, daß hinsichtlich eines sekundärseitigen Stromes eine Unterscheidung dahingehend möglich ist, ob der erfaßte Strom auf einem primärseitig im Leiter des Wechselstrom-Energieübertragungsnetzes fließenden Strom oder auf einem bei unterbrochenem Strom im Leiter von dem Stromwandler hervorgerufenen, abklingenden Gleichstromglied beruht.

Zur Lösung dieser Aufgabe werden bei dem oben aufgeführten Verfahren erfindungsgemäß aus den Abtastwerten mittels mindestens zweier FIR-Filter zwei zueinander orthogonale, erste Meßhilfsgrößen gebildet, in einer Auswerteanordnung wird aus den zwei ersten Meßhilfsgrößen ein der Amplitude der einen Meßgröße entsprechendes Betrags-Signal erzeugt; in der Auswerteanordnung wird unter Verwendung der zwei ersten Meßhilfsgrößen und zweier weiterer zueinander orthogonaler Meßhilfsgrößen, die aus einer vor einer Viertelperiode des zu messenden Stromes gewonnenen älteren Meßgröße gebildeten älteren Abtastwerten erzeugt sind, durch komplexe Division der digitalen Abtastwerte und der älteren digitalen Abtastwerte ein Winkelsignal erzeugt, wenn der Differenzwinkel zwischen den der einen und der älteren Meßgröße entsprechenden komplexen Stromzeigern einen vorgegebenen Schwellwert überschreitet, und in einer Bewertungsanordnung wird ein Ausgangssignal erzeugt, wenn das Winkelsignal erzeugt ist und das Betragssignal einen vorgegebenen anderen Schwellwert überschreitet. Mit FIR-Filter sind dabei sog. Finite-Impulse-Response-Filter bezeichnet, wie sie z.B. in "Elektronik" 2/23.1.1987, Seiten 89 bis 96 beschrieben sind.

Der wesentliche Vorteil des erfindungsgemäßen Verfahrens besteht darin, daß jederzeit festgestellt werden kann, ob ein sekundärseitig erfaßter Strom auf einen Strom durch den Leiter des Wechselstrom-Energieübertragungsnetzes zurückzuführen ist oder auf das abklingende Gleichstromglied des Stromwandlers bei tatsächlich unterbrochenem Stromfluß im Leiter.

Bei dem erfindungsgemäßen Verfahren hat es sich als vorteilhaft erwiesen, wenn aus den Abtastwerten in einem digitalen Hochpaß zunächst eine gefilterte Meßgröße gebildet wird und wenn aus der gefilterten Meßgröße mittels der mindestens zwei FIR-Filter die zwei zueinander orthogonalen ersten Meßhilfsgrößen gebildet werden. Die Bildung der gefilterten Meßgröße hat nämlich den Vorteil, daß durch den Hochpaß der Abklingvorgang des Stromwandlers zeitlich begrenzt werden kann; darüber hinaus lassen sich mit dem Hochpaß in den Abtastwerten womöglich vorhandene Offsetgrößen ausfiltern.

Die Bildung der zwei weiteren Meßhilfsgrößen kann bei dem erfindungsgemäßen Verfahren in unterschiedlicher Weise erfolgen. So wird es als vorteilhaft angesehen, wenn die zwei weiteren Meßhilfsgrößen zur selben Zeit wie die ersten Meßhilfsgrößen gebildet werden, indem die älteren Abtastwerte mindestens zwei weiteren FIR-Filtern zugeführt werden. In diesen zwei weiteren FIR-Filtern werden dann aus den älteren Abtastwerten in entsprechender Weise wie mit den aktuellen Abtastwerten die zwei weiteren zueinander orthogonalen Meßhilfsgrößen gebildet.

Bei dieser Ausführungsform des erfindungsgemäßen Verfahrens wird aus den älteren Abtastwerten in einem weiteren Hochpaß vorteilhafterweise zunächst eine weitere gefilterte Meßgröße gebildet, und es werden aus der weiteren gefilterten Meßgröße mittels der mindestens zwei weiteren FIR-Filter die zwei weiteren Meßhilfsgrößen gebildet.

Bei einer weiteren vorteilhaften Ausführungsform des erfindungsgemäßen Verfahrens werden die zwei weiteren Meßhilfsgrößen mittels einer Verzögerungsanordnung erzeugt, die eingangsseitig mit den zwei ersten Meßhilfsgrößen beaufschlagt ist und aufgrund ihrer einer Viertelperiode des Stromes entsprechenden Verzögerung ausgangsseitig die zwei weiteren Meßhilfsgrößen nach einer Viertelperiode des Stromes zur Verfügung stellt. Bei dieser Ausführungsvariante des erfindungsgemäßen Verfahrens kann also in vorteilhafter Weise auf die zwei weiteren FIR-Filter zur Bildung der weiteren Meßhilfsgrößen verzichtet werden, wodurch in vorteilhafter Weise der Aufwand bei der Durchführung des Verfahrens verringert wird.

Die insgesamt vier Meßhilfsgrößen können bei dem erfindungsgemäßen Verfahren in der Auswerteanordnung in unterschiedlicher Weise ausgewertet werden. Im Hinblick auf einen geringen Aufwand wird es jedoch als vorteilhaft angesehen, wenn jede der ersten Meßhilfsgrößen mit jeder der weiteren Meßhilfsgrößen in der Auswerteanordnung unter Bildung von vier Zwischengrößen multipliziert wird, jeweils zwei aus verschiedenen ersten und zweiten Meßhilfsgrößen gebildete Zwischengrößen in einem Addierer unter Bildung von zwei Hilfsgrößen addiert werden, die eine Hilfsgröße auf ihr Vorzeichen und die andere Hilfsgröße daraufhin untersucht wird, ob sie einen vorgegebenen weiteren Schwellwert überschreitet, und bei Vorliegen beider Bedingungen das Winkelsignal an die Bewertungsanordnung abgegeben wird.

Bei einer anderen Ausführungsform des erfindungsgemäßen Verfahrens zur Lösung der oben angegebenen Aufgabe werden die Abtastwerte einerseits direkt und andererseits nach Verzögerung um eine einer Viertelperiode des Wechsel stromes entsprechenden Zeit zwei FIR-Filtern unter Bildung von jeweils zwei zueinander orthogonalen Filterausgangsgrößen zugeführt, alle Filterausgangsgrößen werden einer Auswerteanordnung zugeführt, die ausgangsseitig einen der Amplitude der einen Meßgröße entsprechenden Meßwert und einen weiteren Meßwert erzeugt, der dem Differenzwinkel zwischen der Meßgröße und einer vor einer Viertelperiode des Stromes gebildeten, älteren Meßgröße entspricht, und aus den beiden Meßwerten wird in einer Bewertungsanordnung (ein Ausgangssignal erzeugt, wenn die Meßwerte vorgegebene Schwellwerte überschreiten.

Mit besonderem Vorteil läßt sich das erfindungsgemäße Verfahren bei einer Einrichtung zur Überwachung eines im Zuge des Leiters des Wechselstrom-Energieübertragungsnetzes angeordneten Leistungsschalters einsetzen, wenn erfindungsgemäß eine Logikschaltung der Einrichtung außer mit einem Auslösesignal einer dem Leistungsschalter zugeordneten Schutzeinrichtung auch mit dem Auslösesignal der Bewertungsanordnung beaufschlagt wird und wenn von der Logikschaltung eine Schalter-Versager-Meldung abgegeben, wenn beim Vorliegen eines Auslösesignals von der Bewertungsanordnung ein Ausgangssignal abgegeben wird. Diese Anwendung des erfindungsgemäßen Verfahrens führt nämlich in vorteilhafter Weise dazu, daß ein bei Stromunterbrechung im Leiter durch die vorhandene Eisenkern-Restmagnetisierung des Stromwandlers verursachtes aperiodisches Gleichstromglied von einem fortdauernd fließenden Strom im Leiter unterschieden werden kann. Mit der Abgabe einer Schalter-Versager-Meldung muß daher nicht eine vorbestimmte Zeit abgewartet werden (Abklingen des Gleichstromgliedes), um eine sichere Erkenntnis über ein Schalterversagen zu gewinnen. Es kann somit schnell eine derartige Schalter-Versager-Meldung abgegeben werden, woraufhin dann andere Schalter des Wechselstrom-Energieübertragungsnetzes für den gestörten Leistungsschalter die Abschaltung vornehmen können.

Die Anwendung des erfindungsgemäßen Verfahrens ist aber keinesfalls auf diesen Anwendungsfall beschränkt; auch bei einem Sammelschienenschutz, wo die Abschaltung eines Abzweiges ebenfalls ein abklingendes Gleichstromglied in dem zugeordneten Stromwandler verursacht, so daß die Stromsummenbildung des Sammelschienenschutzes einen Fehler aufweist, ist das erfindungsgemäße Verfahren mit Vorteil einsetzbar, weil dadurch die Genauigkeit bei der Fehlererfassung erhöht wird.

Zur Erläuterung der Erfindung ist in

Figur 1    ein Blockschaltbild einer Anordnung zur Durchführung einer Ausführungsform des erfindungsgemaßen Verfahrens, in

Figur 2    ein Signalverlauf des Stromes im Leiter eines Wechselstrom-Energieübertragungsnetzes, in

Figur 3    eine Darstellung komplexer Zeiger des Stromes und ein Zeigerbild, in

Figur 4    ein Blockschaltbild einer Anordnung zur Durchführung einer weiteren Ausführungsform des erfindungsgemaßen Verfahrens, in

Figur 5    ein Blockschaltbild einer Anordnung zur Durchführung einer zusätzlichen Ausführungsvariante des erfindungsgemäßen Verfahrens und in

Figur 6    der im Zusammenhang mit der Erfindung wesentliche Teil einer Enrichtung zur Überwachung eines Leistungsschalters wiedergegeben.

Dabei sei ausdrücklich angemerkt, daß die Blockschaltbilder nur gewählt sind, um die Wirkungsweise des erfindungsgemäßen Verfahrens erläutern zu können; zur Durchführung des erfindungsgemäßen Verfahrens wird bevorzugt eine Datenverarbeitungsanlage eingesetzt.

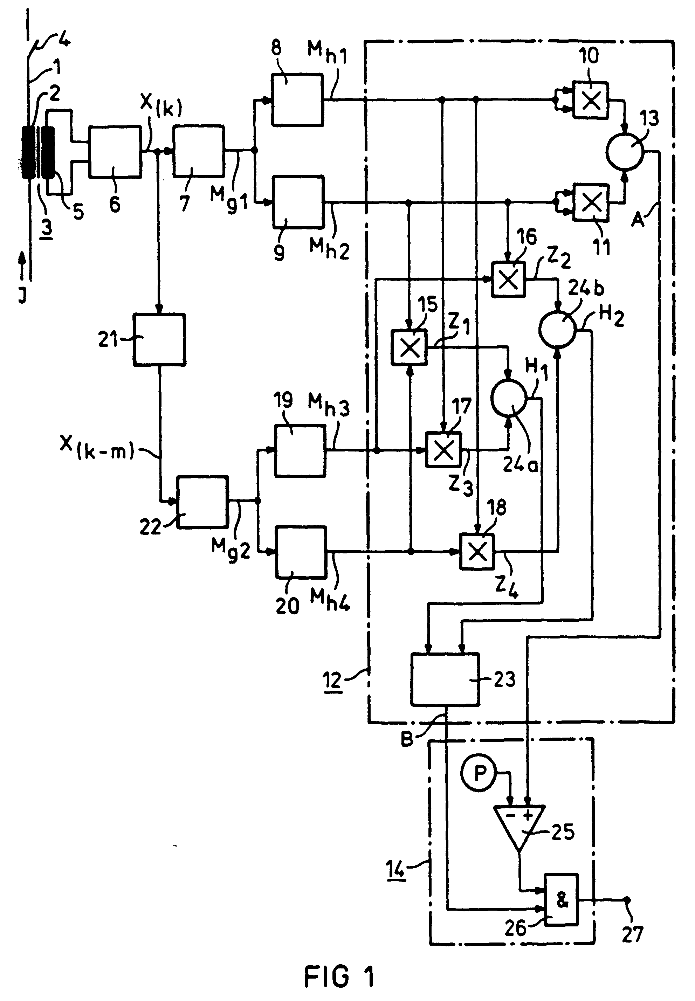

Wie Figur 1 erkennen läßt, ist ein Leiter 1 eines im übrigen nicht weiter dargestellten Wechselstrom-Energieversorgungsnetzes von einem Strom J durchflossen. Im Zuge des Leiters 1 liegt die Primärwicklung 2 eines Stromwandlers 3 sowie ein in der Figur nur schematisch dargestellter Leistungsschalter 4. An die Sekundärwicklung 5 des Stromwandlers 3 ist eine Abtasteinrichtung 6 mit integriertem Analog-Digital-Wandler angeschlossen.

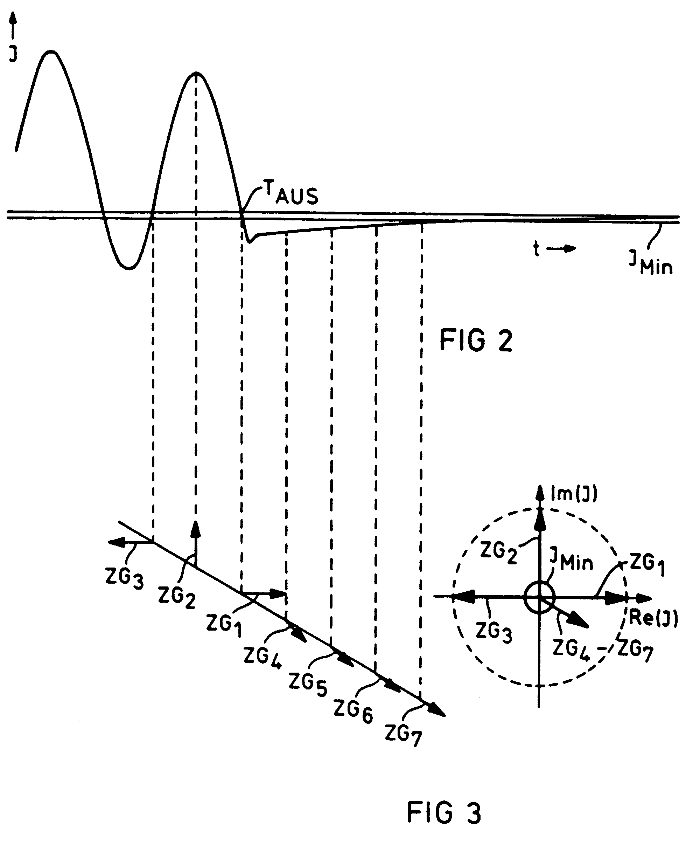

Wenn der Leiter 1 von einem Strom J in Form eines Kurzschlußstromes durchflossen ist, wie er im linken Teil der Figur 2 in Abhängigkeit von der Zeit dargestellt ist, dann wird der Stromfluß durch den Leiter 1 dann unterbrochen, wenn eine dem Leistungsschalter 4 zugeordnete (in der Figur 1 nicht dargestellte) Schutzanordnung ein Auslösesignal abgegeben hat und der Leistungsschalter 4 daraufhin angesprochen hat. Das Ansprechen des Leistungsschalters 4 soll im dargestellten Beispiel zum Zeitpunkt $T_{AUS}$ erfolgt sein. Aufgrund der Eisenkern-Restmagnetisierung des Stromwandlers 3 wird aber auch nach dem Zeitpunkt $T_{AUS}$ von der Abtasteinrichtung 6 ein Sekundär-Strom erfaßt, der ein aperiodisch abklingendes Gleichstromglied darstellt und einen Verlauf hat, wie er im rechten Teil der Figur 2 über der

3

Zeit t dargestellt ist. Das abklingende Gleichstromglied liegt auch nach dem Abschaltzeitpunkt $T_{AUS}$ des Leistungsschalters 4 im Betrage oberhalb eines Schwellwertes $J_{Min,}$ der ebenfalls in Figur 2 eingezeichnet ist.

Der Schwellwert $J_{Min}$ dient zur Feststellung, ob nach Ausgabe eines Auslösesignals einer Schutzanordnung an den dargestellten Leistungsschalter 4 der Stromfluß im Leiter 1 tatsächlich unterbrochen worden ist; wird ein Strom J festgestellt, der in seinem Werte oberhalb des Schwellwertes $J_{Min}$ liegt, dann wird dies als ein Zeichen dafür gewertet, daß der Leistungsschalter 4 nicht vorschriftsmäßig abgeschaltet hat. In diesem Falle müssen andere Leistungsschalter des Wechselstrom-Energieversorgungsnetzes die Funktion des defekten Leistungsschalters übernehmen und das defekte Leitungsstück aus dem Netz heraustrennen.

Wird der sekundärseitige Strom des Stromwandlers 3 nur im Hinblick auf seinen Betrag beurteilt, dann würde in dem in Figur 2 dargestellten Falle fälschlicherweise ein Fehlverhalten des Leistungsschalters 4 registriert werden, weil infolge des abklingenden Gleichstromgliedes ein Strom oberhalb des Schwellwertes $J_{Min}$ erfaßt wird. Unnötigerweise würden ohne weitere Vorkehrungsmaßnahmen benachbarte Leistungsschalter aktiviert werden. Um dies zu verhindern, wartet man bisher eine gewisse Zeit ab, in der das Gleichstromglied normalerweise abgeklungen ist, und überprüft dann noch einmal den Betrag des Stromes J in bezug auf den Schwellwert. Damit ergibt sich aber eine relativ lange Wartezeit.

Dem wird durch Anwendung des erfindungsgemäßen Verfahrens abgeholfen, indem die am Ausgang der Abtasteinrichtung 6 anstehenden digitalen Abtastwerte $X_{(k)}$ zunächst einem digitalen Hochpaß 7 zugeführt werden, in dem der Abklingvorgang des durch den Stromwandler 3 hervorgerufenen Gleichstromgliedes begrenzt wird und in den digitalen Abtastwerten $X_{(k)}$ vorhandene Offsetgrößen ausgefiltert werden. Am Ausgang des Hochpasses 7 entsteht dann eine gefilterte Meßgröße $M_{g1}$. Diese gefilterte Meßgröße $M_{g1}$ wird einem FIR-Filter 8 und einem weiteren FIR-Filter 9 zugeführt. Beide FIR-Filter 8 und 9 sind so bemessen, daß sie an ihren Ausgängen Meßhilfsgrößen $M_{h1}$ und $M_{h2}$ erzeugen, die zueinander orthogonal sind. Die Dimensionierung der beiden FIR-Filter 8 und 9 ist dabei so gewählt, daß die Meßhilfsgröße $M_{h1}$ bei einem sinusförmigen Eingangssignal der Abtasteinrichtung 6 mit der Nennfrequenz, beispielsweise 50 Hz bei einem Wechselstrom-Energieversorgungsnetz, genau um 90° phasengedreht gegenüber der Meßhilfsgröße $M_{h2}$ des FIR-Filters 9 ist; außerdem ist dafür gesorgt, daß beide Meßhilfsgrößen $M_{h1}$ und $M_{h2}$ gleiche Amplitude haben.

Diese Meßhilfsgrößen $M_{h1}$ und $M_{h2}$ werden in Multiplizierern 10 und 11 einer Auswerteanordnung 12 quadriert und anschließend in einem Addierer 13 aufsummiert. Am Ausgang des Addierers 13 ergibt sich dann ein Betragssignal A, das einer Bewertungsanordnung 14 zugeführt wird.

Außerdem ist mit den Meßhilfsgrößen $M_{h1}$ und $M_{h2}$ jeweils ein Eingang von vier Multiplizierern 15, 16, 17 und 18 beaufschlagt, die mit ihrem jeweils weiteren Eingang mit den Ausgängen von zwei weiteren FIR-Filtern 19 und 20 verbunden sind. Diese weiteren FIR-Filter 19 und 20 sind ebenso dimensioniert wie die FIR-Filter 8 und 9 und erzeugen demzufolge bei eingangsseitiger Beaufschlagung mit einer weiteren Meßhilfsgröße $M_{g2}$ an ihren Ausgängen weitere Meßhilfsgrößen $M_{h3}$ und $M_{h4}$, die gleiche Amplitude haben, jedoch in ihrer Phase um 90° gegeneinander gedreht sind.

Die weitere Meßhilfsgröße $M_{g2}$ ist aus den digitalen Abtastwerten $X_{(k)}$ über eine Verzögerungsanordnung 21 und einen weiteren Hochpaß 22 gewonnen. Die Verzögerungsanordnung 21 ist dabei so ausgelegt, daß sie an ihrem Ausgang nach einer Zeitverzögerung von einer Viertelperiode des Stromes J die vor einer Viertelperiode aktuellen Abtastwerte als ältere digitale Abtastwerte $X_{(k-m)}$ abgibt. Dies bedeutet, daß von den einen FIR-Filtern 8 und 9 jeweils aktuelle, digitale Abtastwerte $X_{(k)}$ und zur selben Zeit von den zwei weiteren FIR-Filtern 19 und 20 um eine Viertelperiode des Stromes J ältere, digitale Abtastwerte $X_{(k-m)}$ verarbeitet werden.

Die weiteren Meßhilfsgrößen $M_{h3}$ und $M_{h4}$ werden - wie oben bereits angedeutet - dem jeweils weiteren Eingang der Multiplizierer 15, 16, 17 und 18 in einer Weise zugeführt, wie es aus der Figur 1 hervorgeht. Es bildet sich somit am Ausgang des Multiplizierers 15 eine Zwischengröße $Z_1$, die sich durch folgende Gleichung (1) beschreiben läßt:

$$Z_1 = M_{h2} \times M_{h4} \qquad\qquad (1)$$

Dabei lassen sich $M_{h2}$ sowie $M_{h4}$ durch die Gleichungen (2) und (3) wie folgt darstellen:

$$M_{h2} = G^*X_{(k)} \qquad\qquad (2)$$

$$M_{h4} = G^*X_{(k-m)} \qquad\qquad (3)$$

Dabei bezeichnet * eine Faltungsoperation und G die Übertragungsfunktion des FIR-Filters 9 bzw. des weiteren FIR-Filters 20.

Entsprechend lassen sich die Zwischengröße $Z_2$ am Ausgang des Multiplizierers 16, die Zwischengröße $Z_3$ am Ausgang des Multiplizierers 17 und die Zwischengröße $Z_4$ am Ausgang des Multiplizierers 18 durch folgende Gleichungen (4) bis (8) beschreiben:

$$Z_2 = M_{h2} \times M_{h3} \tag{4}$$

$$Z_3 = M_{h1} \times M_{h3} \tag{5}$$

und

$$Z_4 = M_{h1} \times M_{h4} \tag{6}$$

mit

$$M_{h1} = F^*X_{(k)} \tag{7}$$

und

$$M_{h3} = F^*X_{(k-m)}. \tag{8}$$

Darin bezeichnet F die Übertragungsfunktion des FIR-Filters 8 bzw. des weiteren FIR-Filters 19.

Die Zwischengrößen $Z_1$ und $Z_3$ werden einem weiteren Addierer 24a zugeführt; entsprechend wird mit den Zwischengrößen $Z_2$ und $Z_4$ ein zusätzlicher Addierer 24b beaufschlagt. Am Ausgang des weiteren Addierers 24a entsteht eine Hilfsgröße $H_1$, während am Ausgang des zusätzlichen Addierers 24b eine zusätzliche Hilfsgröße $H_2$ abgegeben wird. Diese Hilfsgrößen $H_1$ und $H_2$ werden einer Schwellwerteinrichtung 23 zugeführt, die ausgangsseitig ein Winkelsignal B abgibt.

Dem insoweit beschriebenen Verfahren nach Figur 1 liegen folgende Überlegungen zugrunde: Durch die Gewinnung der Meßhilfsgrößen $M_{h1}$ und $M_{h2}$ mittels der beiden FIR-Filter 8 und 9 und der nachgeordneten Multiplizierer 10 und 11 sowie des Addierers 13 wird das Betrags-signal A gebildet, das bei sinusförmigem Verlauf des Stromes J im Leiter 1 bzw. im Sekundärstromkreis des Stromwandlers 3 ein Gleichsignal darstellt, das dem Quadrat der Amplitude des aktuellen Stromes im Sekundärkreis des Stromwandlers 3 entspricht. Dies kann mittels folgender Gleichung (9) veranschaulicht werden:

$$A^2 = \left[ \underbrace{X \sin(\omega_o t + \varphi_o)}_{F^*X} \right]^2 + \left[ \underbrace{\hat{X} \sin(\omega_o t + \varphi_o + 90°)}_{G^*X} \right]^2 \tag{9}$$

In dieser Gleichung geben die Größen G und F wiederum die Übertragungsfunktionen der FIR-Filter 8 und 9 wieder; $\omega_0$ bezeichnet die Kreisfrequenz des Stromes J und $\varphi_0$ dessen Phasenlage. Die Gleichung (9)kann auch folgenderweise ausgedrückt werden:

$$A^2 = (G^*X)^2 + (F^*X)^2 \tag{10}$$

Die Differenzwinkelmessung zwischen den digitalen Abtastwerten $X_{(k)}$ und $X_{(k-m)}$ wird auf eine komplexe Division dieser beiden Signale zurückgeführt. Dies läßt sich durch folgende Gleichung (11) allgemein ausdrücken:

$$\frac{X_{(k)} \cdot e^{j\varphi_a}}{X_{(k-m)} \cdot e^{j\varphi_b}} = \frac{X_{(k)}}{X_{(k-m)}} \cdot e^{j(\varphi_a - \varphi_b)} \tag{11}$$

Bei der Darstellung in Polarkoordinaten erkennt man, daß das Divisionsergebnis der beiden komplexen Zeiger den Differenzwinkel der beiden Operanden als Argument hat. Da am Ausgang der FIR-Filter 8,9,19 und 20 die Signale $X_{(k)}$ und $X_{(k-m)}$ nur in kartesischen Koordinaten zur Verfügung stehen, wird die Division auch in kartesischen Koordinaten vorgenommen. Dies läßt sich durch folgende Gleichung (12) allgemein ausdrücken:

$$\frac{a + jb}{c + jd} = \frac{(ac + bd) + j(bc - ad)}{Nenner} \tag{12}$$

Bezogen auf den vorliegenden Fall ist in der Gleichung (12) a durch die Meßhilfsgröße $M_{h1}$, b durch die Meßhilfsgröße $M_{h2}$, c durch die Meßhilfsgröße $M_{h4}$ und d durch die Meßhilfsgröße $M_{h3}$ zu ersetzen. Der Zähler des rechten Bruches der Gleichung (12) läßt sich dann auch folgendermaßen darstellen:

$$(M_{h1} \cdot M_{h4} + M_{h2} \cdot M_{hg3}) + j(M_{h2} \cdot M_{h4} - M_{h1} \cdot M_{h3}) \tag{13}$$

In der oben aufgeführten Gleichung (12) muß der Nenner des aufgeführten Bruches nicht berechnet werden, da der Nenner eine reelle Zahl darstellt und demzufolge hinsichtlich des Differenzwinkels keine Information enthält. Die Information über den Differenzwinkel ist also vollständig im Zähler des angegebenen Bruches enthalten. Die Einzelprodukte im Zähler des Bruches nach der Summation (13) entsprechen den einzelnen Zwischengrößen $Z_1$ bis $Z_4$, die oben definiert worden sind. Die Hilfsgrößen $H_1$ und $H_2$ stellen also eine dem Quotienten der Signale $X_{(k)}$ und $X_{(k-m)}$ proportionalen Zeiger dar. Legt man nun fest, daß dieser Zeiger einen Winkel von $> \pm\ 60°$ aufweisen soll, um mit Sicherheit einen trotz an den Leistungsschalter 4 gegebenen Auslösesignals noch fließenden Strom feststellen zu können, dann läßt sich ein Verletzen dieser Bedingung dadurch meßtechnisch erfassen, daß der Realteil des Zeigers stets positiv und der Imaginärteil des Zeigers größer als tangens 60° x Realteil des Zeigers sein muß.

Um diesen Sachverhalt zu verdeutlichen, wird auf Figur 3 Bezug genommen, in deren linker Darstellung zunächst die Lage des Stromzeigers gemessen am Zeitpunkt $T_{AUS}$ (vgl. Fig. 2) dargestellt ist, wobei zu diesem Zeitpunkt der Zeiger $ZG_1$ die dargestellte Lage einnehmen möge. In bezug auf diesen Zeiger $ZG_1$ haben Zeiger $ZG_2$ und $ZG_3$ zu jeweils einer Viertelperiode des Stromes J früheren Zeitpunkten jeweils um 90° versetzte Positionen. Nach dem Abschaltzeitpunkt $T_{AUS}$ ergeben sich bei unterbrochenem Stromfluß durch den Leiter 1 aufgrund des abklingenden Gleichstromgliedes aus dem Stromwandler 3 in den folgenden Viertelperioden Zeiger $ZG_4$ bis $ZG_7$, die - wie die rechte Darstellung von Figur 3 zeigt - jeweils im vierten Quadranten des dargestellten Zeigerbildes liegen. Dies bedeutet, daß der Imaginärteil der Zeiger $ZG_4$ bis $ZG_7$ seine Position im wesentlichen nicht ändert, wenn ein abklingendes Gleichstromglied erfaßt wird. Dies wird in der Schwellwertanordnung 23 ausgewertet.

In der nachgeordneten Bewertungsanordnung 14 wird das Betragssignal A in einem Komparator 25 daraufhin überprüft, ob ein vorgegebener Schwellwert P überschritten ist. Ist dies der Fall, dann wird an eine als UND-Glied ausgebildete Logikschaltung 26 ein Signal abgegeben. An einem anderen Eingang der Logikschaltung 26 wird von der Schwellwertanordnung 23 das Winkelsignal B geliefert, wenn der Realteil des Zeigers positiv und der Imaginärteil des Zeigers $\geq$ tangens60° x Realteil ist, wie oben ausführlich erläutert worden ist. Dies bedeutet, daß dann kein abklingendes Gleichstromglied erfaßt ist, so daß dann am Ausgang 27 der Logikschaltung 26 eine Schalter-Versager-Meldung erzeugt wird.

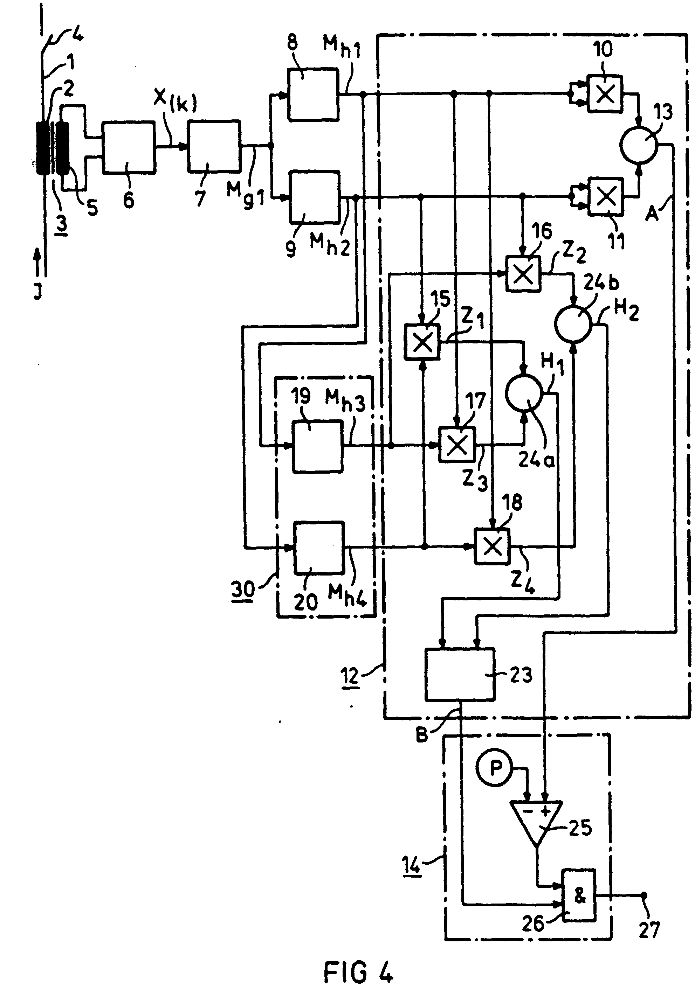

Bei dem Ausführungsbeispiel gemäß Figur 4 sind mit der Ausführungsform nach Figur 1 übereinstimmende Bausteine mit gleichen Bezugszeichen versehen. Es ist zu erkennen, daß im Vergleich zu der Ausführungsform nach Figur 1 hier auf die zwei weiteren FIR-Filter verzichtet ist. Statt dessen werden die beiden weiteren Meßhilfsgrößen $M_{h3}$ und $M_{h4}$ mittels einer Verzögerungsschaltung 30 erzeugt, die für eine Verzögerung der Ausgangssignale (Meßhilfsgrößen $M_{h1}$ und $M_{h2}$) der FIR-Filter 8 und 9 um eine einer Viertelperiode des Stromes J entsprechende Zeitdauer sorgt. Ansonsten arbeitet das Verfahren nach Figur 4 in gleicher Weise, wie es im Zusammenhang mit der Figur 1 ausführlich beschrieben worden ist.

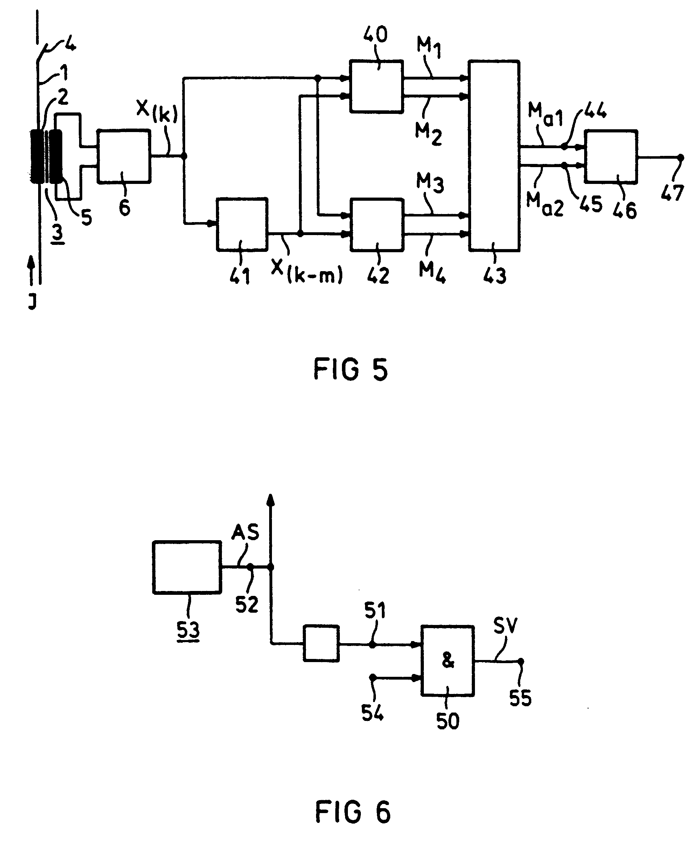

Bei dem Ausführungsbeispiel nach Figur 5 ist der Eingangsteil wiederum so ausgeführt wie bei dem Ausführungsbeispiel nach den Figuren 1 und 4, so daß diesbezüglich auch in der Figur 5 die gleichen Bezugszeichen wie in den Figuren 1 und 4 verwendet sind.

In Abweichung von den vorher beschriebenen Verfahren nach den Figuren 1 und 4 werden hier digitale Abtastwerte $X_{(k)}$ einerseits direkt einem FIR-Filter 40 und andererseits über eine Verzögerungsanordnung 41 einem weiteren FIR-Filter 42 zugeführt. Dadurch ist dafür gesorgt, daß das FIR-Filter 40 mit den jeweils aktuellen Abtastwerten $X_{(k)}$ und das FIR-Filter 42 mit um eine Viertelperiode des Stromes J älteren Abtastwerten und $X_{(k-m)}$ beaufschlagt ist. Die Verzögerung mittels der Schaltung 41 ist deshalb wiederum so gewählt, daß sie einer Viertelperiode des Stromes J im Leiter 1 entspricht.

Ausgangsseitig entstehen an den FIR-Filtern 40 und 42 Größen $M_1$, $M_2$ sowie $M_3$ und $M_4$, die sich in einer Weise beschreiben lassen, wie es in der Literaturstelle "IEEE Transactions on Power Delivery", Vol.7, No. 2, April 1992, Seite 621 beschrieben ist, sofern die FIR-Filter 40 und 42 so bemessen sind, wie es auf derselben Seite dieser Literaturstelle aufgeführt ist. Mittels einer nachgeordneten Rechenschaltung 43 läßt sich dann an einem Ausgang 44 eine abgeleitete Größe $M_{a1}$ und an einem weiteren Ausgang 45 eine weitere abgeleitete Größe $M_{a2}$ erzeugen, wobei die eine abgeleitete Größe $M_{a1}$ dem Betrag des Stromes J und die andere abgeleitete Größe $M_{g2}$ dem Differenzwinkel zwischen den digitalen Abtastwerten $X_{(k)}$ und $X_{(k-m)}$ entspricht. Durch eine nachgeordnete Schwellwerteinrichtung 46 kann dann wiederum festgestellt werden, ob der Differenzwinkel > 60° ist und die Amplitude einen vorgegebenen Schwellwert überschritten hat. In diesem Falle wird dann an einem Ausgang 47 eine Schalter-Versager-Meldung abgegeben.

Fig. 6 zeigt eine als UND-Glied ausgebildete Logikschaltung 50 einer ansonsten nicht weiter dargestellten Einrichtung zur Überwachung des in den Figur 1, 4 und 5 dargestellten Leistungsschalters 4 auf Schalterversagen. Die Logikschaltung 50 ist mit ihrem einen Eingang 51 über eine Verzögerungsschaltung, deren Verzögerung nur geringfügig über der Ausschaltzeit des Leistungsschalters 4 liegen muß, mit einem Ausgang 52 einer dem Leistungsschalter 4 zugeordneten Schutzeinrichtung 53 verbunden und wird beim Auftreten eines Auslösesignals AS für den Leistungsschalter 4 auch mit diesem Signal zeitverzögert beaufschlagt. Außerdem ist ein weiterer Eingang 54 der Logikschaltung 50 mit dem Ausgang 27 der Bewertungsanordnung 14 bzw. mit dem Ausgang 47 der Bewertungsanordnung 46 verbunden; tritt gleichzeitig mit dem verzögerten Auslösesignal AS an den Eingängen der Logikschaltung 50 das Ausgangssignal der Bewertungsanordnung 14 bzw. 46 auf, dann ergibt sich am Ausgang 55 die Schalter-Versager-Meldung SV.

**Patentansprüche**

1.  Verfahren zum Erfassen des Wechselstromes (J) in einem Leiter (1) eines Wechselstrom-Energieübertragungsnetzes, bei dem

    -   mittels eines Stromwandlers (3) eine dem Wechselstrom (J) proportionale Meßgröße gewonnen wird und aus der Meßgröße mittels einer Abtasteinrichtung (6) digitale Abtastwerte ($X_{(k)}$) gebildet werden,

    **dadurch gekennzeichnet,** daß

    -   aus den Abtastwerten ($X_{(k)}$) mittels mindestens zweier FIR-Filter (8,9) zwei zueinander orthogonale, erste Meßhilfsgrößen ($M_{h1}$,$M_{h2}$) gebildet werden,
    -   in einer Auswerteanordnung (12) aus den zwei ersten Meßhilfsgrößen ($M_{h1}$,$M_{h2}$) ein der Amplitude der einen Meßgröße entsprechendes Betrags-Signal (A) erzeugt wird,
    -   in der Auswerteanordnung (12) unter Verwendung der zwei ersten Meßhilfsgrößen ($M_{h1}$,$M_{h2}$) und zweier weiterer zueinander orthogonaler Meßhilfsgrößen ($M_{h3}$, $M_{h4}$), die aus einer vor einer Viertelperiode des zu messenden Stromes (J) gewonnenen älteren Meßgröße gebildeten älteren Abtastwerten ($X_{(k-m)}$) erzeugt sind, durch komplexe Division der digitalen Abtastwerte ($X_{(k)}$) und der älteren digitalen Abtastwerte ($X_{(k-m)}$) ein Winkelsignal (B) erzeugt wird, wenn der Differenzwinkel zwischen den der einen und der älteren Meßgröße entsprechenden komplexen Stromzeigern einen vorgegebenen Schwellwert überschreitet, und
    -   in einer Bewertungsanordnung (14) ein Ausgangssignal erzeugt wird, wenn das Winkelsignal (B) erzeugt ist und das Betragssignal (A) einen vorgegebenen anderen Schwellwert überschreitet.

2.  Verfahren nach Anspruch 1,
    **dadurch gekennzeichnet,** daß

    -   aus den Abtastwerten ($X_{(k)}$) in einem digitalen Hochpaß zunächst eine gefilterte Meßgröße ($M_{g1}$) gebildet wird und
    -   aus der gefilterten Meßgröße ($M_{g1}$) mittels der mindestens zwei FIR-Filter (8,9) die zwei zueinander orthogonalen ersten Meßhilfsgrößen ($M_{h1}$,$M_{h2}$) gebildet werden.

3.  Verfahren nach Anspruch 1 oder 2,

**dadurch gekennzeichnet,** daß

- die zwei weiteren Meßhilfsgrößen ($M_{h3}$,$M_{h4}$) zur selben Zeit wie die ersten Meßhilfsgrößen ($M_{h1}$,$M_{h2}$) gebildet werden, indem

  - die älteren Abtastwerte ($X_{(k-m)}$) mindestens zwei weiteren FIR-Filtern (19,20) zugeführt werden.

4. Verfahren nach Anspruch 3,
   **dadurch gekennzeichnet,** daß

   - aus den älteren Abtastwerten ($X_{(k-m)}$) in einem weiteren Hochpaß (22) zunächst eine weitere gefilterte Meßgröße ($M_{g2}$) gebildet wird und
   - aus der weiteren gefilterten Meßgröße ($M_{g2}$) mittels der mindestens zwei weiteren FIR-Filter (19,20) die zwei weiteren Meßhilfsgrößen ($M_{h3}$,$M_{h4}$) gebildet werden.

5. Verfahren nach Anspruch 1 oder 2,
   **dadurch gekennzeichnet,** daß

   - die zwei weiteren Meßhilfsgrößen ($M_{h3}$,$M_{h4}$) mittels einer Verzögerungsanordnung (30) erzeugt werden, die

     - eingangsseitig mit den zwei ersten Meßhilfsgrößen ($M_{h1}$,$M_{h2}$) beaufschlagt ist und
     - aufgrund ihrer einer Viertelperiode des Stromes (J) entsprechenden Verzögerung ausgangsseitig die zwei weiteren Meßhilfsgrößen ($M_{h3}$,$M_{h4}$) nach einer Viertelperiode des Stromes (J) zur Verfügung stellt.

6. Verfahren nach einem der vorangehenden Ansprüche,
   **dadurch gekennzeichnet,** daß

   - jede der ersten Meßhilfsgrößen ($M_{h1}$,$M_{h2}$) mit jeder der weiteren Meßhilfsgrößen ($M_{h3}$,$M_{h4}$)in der Auswerte-anordnung (12) unter Bildung von vier Zwischengrößen ($Z_1$,$Z_2$, $Z_3$, $Z_4$) multipliziert wird,
   - jeweils zwei aus verschiedenen ersten und zweiten Meßhilfsgrößen gebildete Zwischengrößen ($Z_1$,$Z_3$;$Z_2$,$Z_4$) in einem Addierer (24a;24b)unter Bildung von zwei Hilfsgrößen ($H_1$;$H_2$) addiert werden,
   - die eine Hilfsgröße ($H_2$) auf ihr Vorzeichen und die andere Hilfsgröße ($H_1$) daraufhin untersucht wird, ob sie einen vorgegebenen weiteren Schwellwert überschreitet, und
   - bei Vorliegen beider Bedingungen das Winkelsignal an die Bewertungsanordnung (14) abgegeben wird.

7. Verfahren nch einem der vorangehenden Ansprüche,
   **dadurch gekennzeichnet,** daß

   - die beiden ersten Meßhilfsgrößen ($M_{h1}$,$M_{h2}$) für sich quadriert und
   - unter Bildung des Betragssignals (A) in einem Addierer (13) aufsummiert werden.

8. Verfahren zum Erfassen des Wechselstromes (J) in einem Leiter (1) eines Wechselstrom-Energieübertragungsnetzes, bei dem

   - mittels eines Stromwandlers (3) eine dem Wechselstrom (J) proportionale Meßgröße gewonnen wird und aus der Meßgröße mittels einer Abtasteinrichtung (6) digitale Abtastwerte ($X_{(k)}$) gebildet werden,

   **dadurch gekennzeichnet,** daß

   - die Abtastwerte ($X_{(k)}$)einerseits direkt und andererseits nach Verzögerung um eine einer Viertelperiode des Wechselstromes (J) entsprechenden Zeit zwei FIR-Filtern (40,42) unter Bildung von jeweils zwei zueinander orthogonalen Filterausgangsgrößen ($M_1$,$M_2$,$M_3$,$M_4$) zugeführt werden,
   - alle Filterausgangsgrößen ($M_1$,$M_2$,$M_3$,$M_4$) einer Auswerteanordnung (43) zugeführt werden, die

     - ausgangsseitig einen der Amplitude der einen Meßgröße entsprechenden Meßwert ($M_{a1}$) und einen wei-teren Meßwert
     - ($M_{a2}$) erzeugt, der dem Differenzwinkel zwischen den der Meßgröße und einer vor einer Viertelperiode des Stromes gebildeten, älteren Meßgröße entsprechenden komplexen Stromzeigern entspricht, und

8

- aus den beiden Meßwerten ($M_{a1}$, $M_{a2}$) in einer Bewertungsanordnung (46) ein Ausgangssignal erzeugt wird, wenn die Meßwerte ($M_{a1}$, $M_{a2}$) vorgegebene Schwellwerte überschreiten.

9. Anwendung des Verfahrens nach einem der vorangehenden Ansprüche bei einer Einrichtung zur Überwachung eines im Zuge des Leiters (1)des Wechselstrom-Energieübertragungsnetzes angeordneten Leistungsschalters (4),
**dadurch gekennzeichnet,** daß

- eine Logikschaltung (50) der Einrichtung außer mit einem Auslösesignal (AS) einer dem Leistungsschalter (4) zugeordneten Schutzeinrichtung (53) auch mit dem Ausgangssignal der Bewertungsanordnung (14,46) beaufschlagt wird,
- von der Logikschaltung (50) eine Schalter-Versager-Meldung (SV) abgegeben wird, wenn beim Vorliegen eines Auslösesignals (AS) von der Bewertungsanordnung (14,46) ein Ausgangssignal abgegeben wird.

**Claims**

1. Method for determining the alternating current (J) in a conductor (1) of an alternating-current energy transmission network in which

- a measured variable which is proportional to the alternating current (J) is obtained by means of a current transformer (3) and digital sample values ($X_{(k)}$) are formed from the measured variable by means of a sampling device (6),

characterized in that

- two mutually orthogonal, first measured auxiliary variables ($M_{h1}$, $M_{h2}$) are formed from the sample values ($X_{(k)}$) by means of at least two FIR filters (8, 9),
- an absolute-value signal (A) corresponding to the amplitude of one measured variable is generated in an evaluation system (12) from the two first measured auxiliary variables ($M_{h1}$, $M_{h2}$),
- in the evaluation system (12), an angular signal (B) is generated using the two first measured auxiliary variables ($M_{h1}$, $M_{h2}$) and two further mutually orthogonal measured auxiliary variables ($M_{h3}$, $M_{h4}$) which have been generated from older sample values ($X_{(k-m)}$) formed from an older measured variable obtained prior to one quarter cycle of the current (J) to be measured, by complex division of the digital sample values ($X_{(k)}$) and the older digital sample values ($X_{(k-m)}$) if the differential angle between the complex current phasors corresponding to one measured variable and the older measured variable exceeds a specified threshold value, and
- an output signal is generated in a rating system (14) if the angular signal (B) has been generated and the absolute-value signal (A) exceeds another specified threshold value.

2. Method according to Claim 1, characterized in that

- a filtered measured variable ($M_{g1}$) is first formed from the sample values ($X_{(k)}$) in a digital high-pass filter and
- the two mutually orthogonal first measured auxiliary variables ($M_{h1}$, $M_{h2}$) are formed from the filtered measured variable ($M_{g1}$) by means of the at least two FIR filters (8, 9).

3. Method according to Claim 1 or 2, characterized in that

- the two further measured auxiliary variables ($M_{h3}$, $M_{h4}$) are formed at the same time as the first measured auxiliary variables ($M_{h1}$, $M_{h2}$) by

  - feeding the older sample values ($X_{(k-m)}$) to at least two further FIR filters (19, 20).

4. Method according to Claim 3, characterized in that

- a further filtered measured variable ($M_{g2}$) is first formed from the older sample values ($X_{(k-m)}$) in a further high-pass filter (22) and
- the two further measured auxiliary variables ($M_{h3}$, $M_{h4}$) are formed from the further filtered measured variable ($M_{g2}$) by means of the at least two further FIR filters (19, 20).

**5.** Method according to Claim 1 or 2, characterized in that

- the two further measured auxiliary variables ($M_{h3}$, $M_{h4}$) are generated by means of a delay system (30) which

  - has the two first measured auxiliary variables ($M_{h1}$, $M_{h2}$) applied to it on the input side and
  - provides on the output side, because of its delay corresponding to one quarter cycle of the current (J), the two further measured auxiliary variables ($M_{h3}$, $M_{h4}$) after one quarter cycle of the current (J).

**6.** Method according to one of the preceding claims, characterized in that

- each of the first measured auxiliary variables ($M_{h1}$, $M_{h2}$) is multiplied by each of the further measured auxiliary variables ($M_{h3}$, $M_{h4}$) in the evaluation system (12) to form four intermediate variables ($Z_1$, $Z_2$, $Z_3$, $Z_4$),
- two intermediate variables ($Z_1$, $Z_3$; $Z_2$, $Z_4$) formed from different first and second measured auxiliary variables are respectively added in an adder (24a; 24b) to form two auxiliary variables ($H_1$; $H_2$),
- one auxiliary variable ($H_2$) is examined for its sign and the other auxiliary variable ($H_1$) is then examined to determine whether it exceeds a specified further threshold value and,
- if both conditions are present, the angular signal is emitted to the rating system (14).

**7.** Method according to one of the preceding claims, characterized in that

- the first two measured auxiliary variables ($M_{h1}$, $M_{h2}$) are squared separately and
- are summed in an adder (13) to form the absolute-value signal.

**8.** Method for determining the alternating current (J) in a conductor (1) of an alternating-current energy transmission network, in which

- a measured variable which is proportional to the alternating current (J) is obtained by means of a current transformer (3) and digital sample values ($X_{(k)}$) are formed from the measured variable by means of a sampling device (6),

characterized in that

- the sample values ($X_{(k)}$) are fed, on the one hand, directly and, on the other hand, after delay by a time corresponding to one quarter cycle of the alternating current (J), to two FIR filters (40, 42) to form in each case two mutually orthogonal filter output variables ($M_1$, $M_2$, $M_3$, $M_4$),
- all the filter output variables ($M_1$, $M_2$, $M_3$, $M_4$) are fed to an evaluation system (43)

  - which generates, on the output side, a measured value ($M_{a1}$) corresponding to the amplitude of one measured variable and a further measured value ($M_{a2}$) which corresponds to the differential angle between the complex current phasors corresponding to the measured variable and an older measured variable formed prior to one quarter cycle of the current, and

- an output signal is generated from the two measured values ($M_{a1}$, $M_{a2}$) in a rating system (46) if the measured values ($M_{a1}$, $M_{a2}$) exceed specified threshold values.

**9.** Application of the method according to one of the preceding claims in a device for monitoring a power circuit-breaker (4) disposed in the conductor (1) of the alternating-current energy transmission network, characterized in that

- a logic circuit (50) of the device has applied to it not only a tripping signal (AS) of a protective device (53) assigned to the power circuit-breaker (4), but also the output signal of the rating system (14, 46),
- a circuit-breaker failure message (SV) is emitted by the logic circuit (50) if an output signal is emitted by the rating system (14, 46) if a tripping signal (AS) is present.

**Revendications**

**1.** Procédé de détection du courant alternatif (J) passant dans un conducteur (1) d'un réseau de transport d'énergie en courant alternatif, dans lequel

- on obtient au moyen d'un transformateur de courant (3) une grandeur mesurée proportionnelle au courant alternatif (J) et on forme à partir de la grandeur mesurée et au moyen d'un dispositif d'échantillonnage (6) des valeurs échantillonnées numériques ($X_{(k)}$),

  caractérisé par le fait que

- on forme à partir des valeurs échantillonnées ($X_{(k)}$) et au moyen d'au moins deux filtres FIR (8, 9) deux premières grandeurs mesurées auxiliaires ($M_{h1}$, $M_{h2}$) orthogonales l'une à l'autre,
- dans un dispositif de traitement (12), on produit à partir des deux premières grandeurs mesurées auxiliaires ($M_{h1}$, $M_{h2}$) un signal en valeur absolue (A) correspondant à l'amplitude d'une première grandeur mesurée,
- dans le dispositif de traitement (12) et en utilisant les deux premières grandeurs mesurées auxiliaires ($M_{h1}$, $M_{h2}$) et deux autres grandeurs mesurées auxiliaires ($M_{h3}$, $M_{h4}$) orthogonales l'une à l'autre qui ont été produites à partir de valeurs échantillonnées antérieures ($X_{(k-m)}$) formées à partir d'une grandeur mesurée antérieure obtenue un quart de période du courant à mesurer (J) avant, on produit par une division complexe des valeurs échantillonnées numériques ($X_{(k)}$) et des valeurs échantillonnées numériques antérieures ($X_{(k-m)}$) un signal d'angle (B) lorsque l'angle de différence entre les vecteurs de courant complexes correspondant à la première grandeur mesurée et à la grandeur mesurée antérieure dépasse une valeur de seuil prescrite, et que
- dans un dispositif d'estimation (14), on produit un signal de sortie lorsque le signal d'angle (B) est produit et lorsque le signal de valeur absolue (A) dépasse une autre valeur de seuil prescrite.

2. Procédé selon la revendication 1,
   caractérisé par le fait que

   - à partir des valeurs échantillonnées (X(k)), on forme d'abord dans un filtre passe-haut numérique (7) une grandeur mesurée filtrée ($M_{g1}$), et que
   - à partir de la grandeur mesurée filtrée ($M_{g1}$) et au moyen des - au moins - deux filtres FIR (8, 9), on forme les deux premières grandeurs mesurées auxiliaires ($M_{h1}$, $M_{h2}$) orthogonales l'une à l'autre.

3. Procédé selon la revendication 1 ou 2,
   caractérisé par le fait que

   - on forme les deux autres grandeurs mesurées auxiliaires ($M_{h3}$, $M_{h4}$) au même moment que les premières grandeurs mesurées auxiliaires ($M_{h1}$, $M_{h2}$),
   - en envoyant les valeurs échantillonnées antérieures ($X_{(k-m)}$) à au moins deux autres filtres FIR (19, 20).

4. Procédé selon la revendication 3,
   caractérisé par le fait que

   - à partir des valeurs échantillonnées antérieures ($X_{(k-m)}$), on forme d'abord dans un autre filtre passe-haut (22) une autre grandeur mesurée filtrée ($M_{g2}$), et que
   - à partir de l'autre grandeur mesurée filtrée ($M_{g2}$) et au moyen des - au moins - deux autres filtres FIR (19, 20), on forme les deux autres grandeurs mesurées auxiliaires ($M_{h3}$, $M_{h4}$).

5. Procédé selon la revendication 1 ou 2,
   caractérisé par le fait que

   - on produit les deux autres grandeurs mesurées auxiliaires ($M_{h3}$, $M_{h4}$) au moyen d'un dispositif de retardement (30)

     - qui reçoit en entrée les deux premières grandeurs mesurées auxiliaires ($M_{h1}$, $M_{h2}$) et
     - qui, en raison de son retard correspondant à un quart de période du courant (J), fournit en sortie les deux autres grandeurs mesurées auxiliaires ($M_{h3}$, $M_{h4}$) après un quart de période du courant (J).

6. Procédé selon l'une des revendications précédentes,
   caractérisé par le fait que

- dans le dispositif de traitement (12), on multiplie chacune des premières grandeurs mesurées auxiliaires ($M_{h1}$, $M_{h2}$) par chacune des autres grandeurs mesurées auxiliaires ($M_{h3}$, $M_{h4}$) en formant quatre grandeurs intermédiaires ($Z_1$, $Z_2$, $Z_3$, $Z_4$),
- à chaque fois, on additionne deux grandeurs intermédiaires ($Z_1$, $Z_3$ ; $Z_2$, $Z_4$), formées à partir de différentes premières et deuxièmes grandeurs mesurées auxiliaires, dans un additionneur (24a ; 24b) en formant deux grandeurs auxiliaires ($H_1$ ; $H_2$),
- on examine le signe de la grandeur auxiliaire ($H_2$) et la valeur de l'autre grandeur auxiliaire ($H_1$) pour savoir si elle dépasse une autre valeur de seuil prescrite, et que
- en présence des deux conditions, on envoie le signal d'angle au dispositif d'estimation (14).

7. Procédé selon l'une des revendications précédentes,
     caractérisé par le fait que

   - on élève au carré les deux premières grandeurs mesurées auxiliaires ($M_{h1}$, $M_{h2}$), et que
   - on les additionne dans un additionneur (13) en formant le signal de valeur absolue (A).

8. Procédé pour la détection du courant alternatif (J) dans un conducteur (1) d'un réseau de transport d'énergie en courant alternatif, dans lequel

   - on obtient au moyen d'un transformateur de courant (3) une grandeur mesurée proportionnelle au courant alternatif (J) et on forme à partir de la grandeur mesurée et au moyen d'un dispositif d'échantillonnage (6) des valeurs échantillonnées numériques ($X_{(k)}$),

     caractérisé par le fait que

   - on envoie les valeurs échantillonnées ($X_{(k)}$), d'une part directement et d'autre part après un retard d'un temps correspondant à un quart de période du courant alternatif (J), à deux filtres FIR (40, 42) en formant respectivement deux grandeurs de sortie de filtre ($M_1$, $M_2$, $M_3$, $M_4$) orthogonales l'une à l'autre,
   - on envoie toutes les grandeurs de sortie de filtre ($M_1$, $M_2$, $M_3$, $M_4$) à un dispositif de traitement (43)

     - qui produit en sortie une valeur mesurée ($M_{a1}$) correspondant à l'amplitude d'une première grandeur mesurée et une autre valeur mesurée ($M_{a2}$) qui correspond à l'angle de différence entre les vecteurs de courant complexes correspondant à la grandeur mesurée et à une grandeur mesurée antérieure formée un quart de période du courant avant, et que

   - à partir des deux valeurs mesurées ($M_{a1}$, $M_{a2}$), on produit dans un dispositif d'estimation (46) un signal de sortie lorsque les valeurs mesurées ($M_{a1}$, $M_{a2}$) dépassent des valeurs de seuil prescrites.

9. Utilisation du procédé selon l'une des revendications précédentes dans un dispositif pour le contrôle d'un interrupteur de puissance (4) monté le long du conducteur (1) du réseau de transport d'énergie en courant alternatif,
     caractérisée par le fait que

   - un circuit logique (50) du dispositif reçoit, outre un signal de déclenchement (AS) d'un dispositif de protection (53) associé à l'interrupteur de puissance (4), le signal de sortie du dispositif d'estimation (14, 46),
   - le circuit logique (50) envoie un message de défaillance d'interrupteur (SV) lorsque, en présence d'un signal de déclenchement (AS), le dispositif d'estimation (14, 46) émet un signal de sortie.

FIG 1

FIG 2

FIG 3

FIG 4

FIG 5

FIG 6